Europäisches Patentamt

European Patent Office

Office européen des brevets

(11) Publication number: **0 460 564 A1**

## EUROPEAN PATENT APPLICATION

(21) Application number: 91109013.2

(22) Date of filing: 03.06.91

(51) Int. Cl.5: **H03F 3/45**

(30) Priority: **04.06.90 JP 145827/90**

(43) Date of publication of application:
**11.12.91 Bulletin 91/50**

(84) Designated Contracting States:
**DE FR NL**

(71) Applicant: **SUMITOMO ELECTRIC INDUSTRIES, LTD.**
**5-33, Kitahama 4-chome, Chuo-ku**
**Osaka-shi, Osaka 541(JP)**

(72) Inventor: **Hirakata, Noriyuki, c/o Yokohama**
**Works Sumitomo**
**El. Ind. Limited, 1, Taya-cho, Sakae-ku**
**Yokohama-shi, Kanagawa(JP)**

(74) Representative: **Patentanwälte Grünecker,**
**Kinkeldey, Stockmair & Partner**
**Maximilianstrasse 58**
**W-8000 München 22(DE)**

(54) Differential amplifier circuit.

(57) A differential amplifier circuit suitable for amplifying a faint signal such as an output of various sensors. The differential amplifier (21) circuit includes switching units (12,13) which are provided at input and output side of a differential amplifier (11) to switch the polarities of an input signal and an output signal of the differential amplifier (11) so as to remove an Offset voltage. The differential amplifier circuit (21) always operates as an ideal amplifier.

FIG. 1

EP 0 460 564 A1

## BACKGROUND OF THE INVENTION

The present invention relates to a differential amplifier circuit.

A differential amplifier is suitable for amplifying a faint signal such as an output of various sensors because the differential amplifier can reduce an adverse effect of a noise effectively. The forward threshold voltage of an Si bipolar junction transistor is determined depending on a band gap which is a physical constant of Si and such an Si bipolar junction transistor is therefore hardly affected by fluctuations in manufacturing process, so that with such an Si bipolar junction transistor being used as an input active element of a differential amplifier, a small offset voltage (several tens $\mu$V) can be realized. Accordingly, the silicon (Si) bipolar junction transistor has been generally used as an input active element of the differential amplifier. However, if an ambient temperature becomes considerably higher than a room temperature, excitation of electrons from a valence band into a conduction band occurs in such an Si bipolar junction transistor so that normal operation is not performed. Consequently, there has been a variety of trials of constituting a differential amplifier by a transistor formed of a material other than Si such as GaAs or the like, having a larger band gap than Si so that the transistor can withstand a high temperature environment. At present, it is field effect transistors (FETs) that are in a stage of practical use in a mass-production level as transistors using new materials such as GaAs or the like.

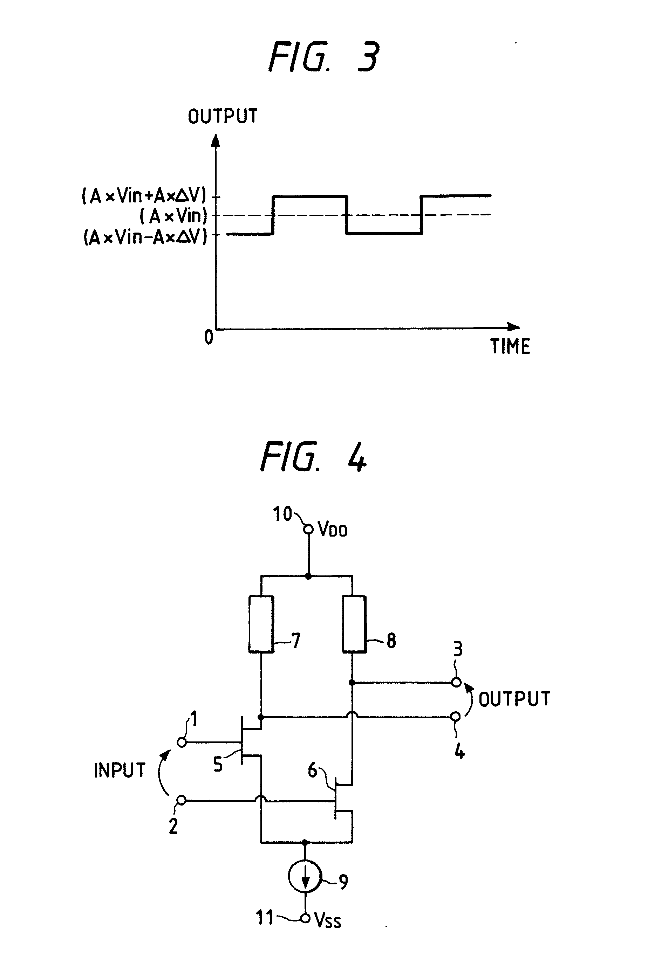

Fig. 4 is a circuit diagram showing a differential amplifier using GaAs MESFETs. In Fig. 4, reference numerals 1 and 2 designate input terminals respectively; 3 and 4, output terminals; 5 and 6, GaAs MESFETs; 7 and 8, load elements; 9, a constant-current regulated power source; 10, a high potential side power supply terminal; and 11, a low potential side power supply terminal.

In such a differential amplifier as shown in Fig. 4, the difference in threshold voltages between the FETs 5 and 6 causes an equivalent input offset voltage. The threshold voltage of an FET depends on the concentration of impurity doped below a gate electrode. Therefore, the threshold voltage varies extremely depending on the manufacturing process. Accordingly, in the case of such a differential amplifier as shown in Fig. 4, there often occurs the equivalent input offset voltage of several tens mV. The output voltage becomes a value of the equivalent input offset voltage multiplied by a gain of the differential amplifier thereby resulting in an occurrence of an extremely large error.

## SUMMARY OF THE INVENTION

In view of the above, an object of the present invention is to solve such a problem accompanying the conventional differential amplifier circuit.

In order to solve the above and other problems, according to the present invention, a differential amplifier circuit having input terminals to which input signals are applied comprising:

a first switching unit for inverting the polarity of a signal representing a potential difference between the input signals;

a differential amplifier for amplifying an output of the first switching unit; a second switching unit for inverting the polarity of an output signal of the differential amplifier in synchronization with the switching of the first switching unit;

and a low-pass filter for removing an AC component from an output of the second switching unit to be output as an output of the differential amplifier circuit.

With such a differential amplifier circuit, when the first switching means and the second switching means are switched in accordance with a switching control signal having a duty ratio of 50%, a voltage which has an amplitude twice as much as an offset voltage and which has a central value equal to the voltage occurring in the case where the differential amplifier is of an ideal one as an output of the second switching means. An AC component of this voltage is removed by the low pass filter, so that a DC component of the same, that is, the voltage in the case where the differential amplifier is of an ideal one is obtained as the output voltage.

## BRIEF DESCRIPTION OF THE INVENTION

In the accompanying drawings;

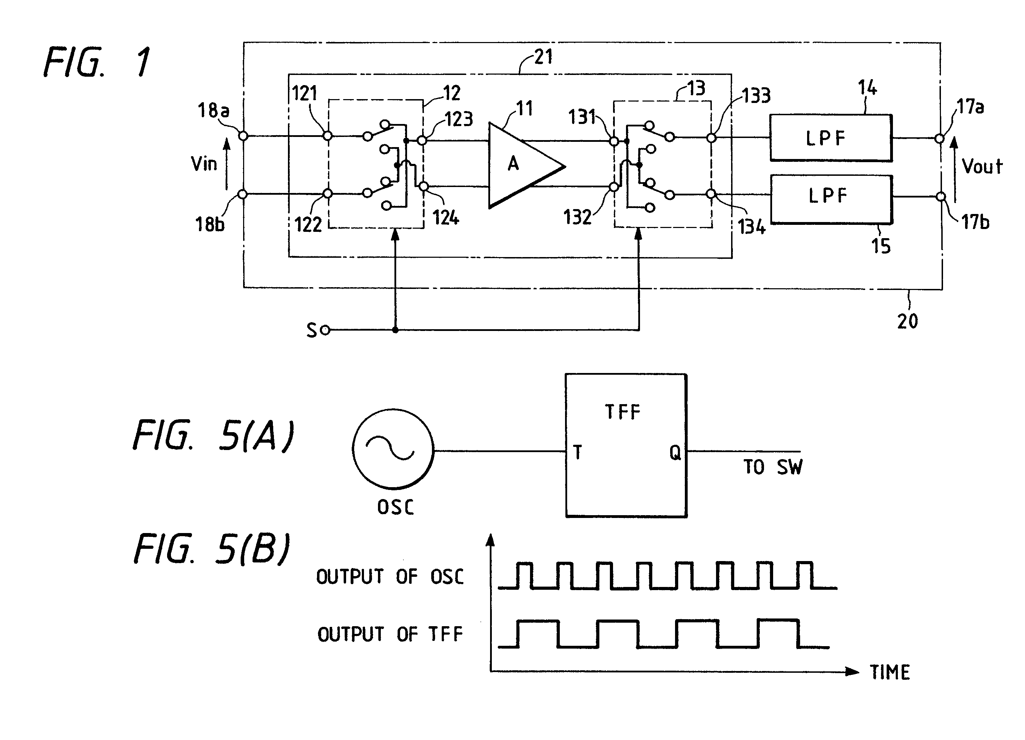

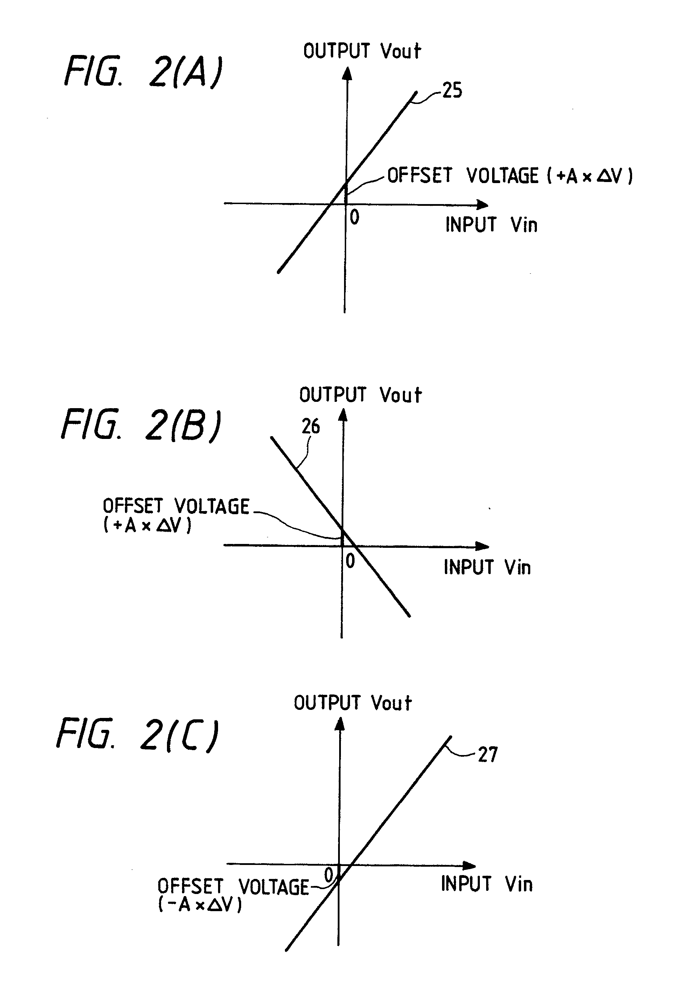

Fig. 1 is a circuit diagram showing an embodiment of the present invention; Figs. 2 (a) to 2(c) are diagrams input/output characteristics of the inside differential amplifier circuit; Fig. 3 is a diagram showing a waveform of an output signal of the inside differential amplifier circuit; Fig. 4 is a circuit diagram of a differential amplifier using GaAs MESFETs; Fig. 5(a) is a circuit diagram showing an example of a switching circuit; and Fig. 5(b) is a waveform diagram showing a waveform of outputs of an oscillator and toggle flip-flop circuit.

## DESCRIPTION OF THE PREFERRED EMBODIMENT

Fig. 1 is a block diagram showing an embodiment of the present invention. A differential amplifier 11 employs GaAs MESFETs as input active elements. An example of the differential amplifier 11 is as shown in Fig. 4. The differential amplifier 11 has a gain A and has an equivalent input offset voltage of $+\Delta V$. A first switching unit 12 including a pair of switches is provided on the input side of the differential amplifier 11. Input terminals 121 and 122 of the first switching unit 12 are connected to input terminals 18a and 18b of a differential amplifier circuit 20 ,respectively, so as to perform polarity inversion switching of an input voltage $V_{in}$ applied to across the input terminals 18a and 18b. Output terminals 123 and 124 of the first switching unit 12 are connected to two input terminals of the differential amplifier 11 respectively. A second switching unit 13 is provided on the output side of the differential amplifier 11. The second switching unit 13 including a pair of switches has the same function as that of the first switching unit 12 so as to perform polarity inversion switching of the voltage applied to across input terminals 131 and 132 thereof. Low pass filters 14 and 15 are connected to output terminals 133 and 134 of the second switching unit 13, respectively. The output terminals of the low pass filters 14 and 15 are connected to output terminals 17a and 17b of the differential amplifier circuit 20, respectively.

The relation between the input voltage $v_{in}$ applied across the input terminals 121 and 122 of the first switching unit 12 and an output voltage $v_{out}$ obtained across the output terminals 133 and 134 of the second switching unit 13, that is, an input/output characteristic of an inside differential amplifier circuit 21 in which the first switching unit 12 and the second switching unit 13 are provided to the differential amplifier 11 will be described. In order to make the description clear, in each of the first switching unit 12 and the second switching unit 13, the connection state in which polarity is not inverted (the connection state shown in Fig. 1) is referred to as a first position and the connection state in which polarity is inverted is referred to as a second position. Fig. 2(A) shows the input/output characteristic in the case where both the first switching unit 12 and the second switching unit 13 are in the first position, which is nothing but an original input/output characteristic of the differential amplifier 11. A characteristic curve 25 has a positive slope having an offset voltage $(+A \times \Delta V)$ obtained by multiplying an equivalent input offset voltage $(+\Delta V)$ by the gain A. Fig. 2(B) shows an input/output characteristic in the case where only the first switching unit 12 is switched so as to be in the second position. A characteristic curve 26 in Fig. 2(B) has a negative slope but has the same offset voltage $(+A \times \Delta V)$ with the same polarity as that of the curve 25. Fig. 2(C) shows an input/output characteristic in the case where both the first switching unit 12 and the second switching unit 13 are in the second position. In this case, a characteristic curve 27 has a positive slope having the same as that of the characteristic curve 25, but the polarity of the offset voltage is inverted so as to be a value of $(-A \times \Delta V)$.

The differential amplifier circuit 20 of this embodiment uses the characteristics of Figs. 2(A) and (C). The operation of this embodiment will be described hereunder.

A binary switching control signal S having a duty ratio of 50% is applied commonly to the first switching means 12 and the second switching unit 13. Both the first switching unit 12 and the second switching unit 13 are adapted to be put in the first position when the switching control signal is of a high level "H", whereas to be put in the second position when the switching control signal is of a low level "L". Accordingly, the inside differential amplifier 21 shows the input/output characteristic of Fig. 2(A) when the switching control signal S is of "H", while shows the input/output characteristic of Fig. 2(C) when the switching control signal S is of "L". Assuming that the output voltage of the inside differential amplifier 21 is $V_{01}$ when the switching control signals is of "H",

$$V_{01} = A \times (V_{in} + \Delta V)$$
$$= A \times V_{in} + A \times \Delta V \text{ ----- (1)}$$

Assuming that the output voltage of the inside differential amplifier 21 is $V_{02}$ when the switching control signal is of "L",

$$V_{02} = A \times (V_{in} - \Delta V)$$

$$= A \times V_{in} - A \times \Delta V \ \text{-----} \ (2)$$

Accordingly, the output voltage of the inside differential amplifier 21 shows a waveform having a center of $A \times V_{in}$ and an amplitude of $2 \times A \times \Delta V$. Fig. 3 shows a waveform of an output voltage of the inside differential amplifier 21 when the input voltage $V_{in}$ is constant. In Fig. 3, the central output voltage $A \times V_{in}$ of the inside differential amplifier 21 is indicated by a dot line and the output voltage of the same is indicated by a solid line.

The output voltage of the inside differential amplifier 21 appears across the output terminals 17a and 17b through the low pass filters 14 and 15. Cut-off frequencies of the low pass filters 14 and 15 are selected so as to be sufficiently lower than the frequency of the switching control signals. Accordingly, the output voltage obtained across the output terminals 17a and 17b is a time-averaged DC component because an AD component is removed from the output voltage of the inside differential amplifier 21, that is, the output voltage becomes a value of $A \times V_{in}$ which is equal to an output voltage of an ideal differential amplifier having no offset voltage.

A concrete example of utility of the differential amplifier circuit according to the present invention will be described.

As mentioned above, the differential amplifier circuit of the invention is used to amplify an output of various sensors. An example of such sensors is a sensor which is provided with a hole elements to detect the crank angle of a rotation shaft of a combustion engine to accomplish the control of air/fuel ratio, the control of ignition timing and the like. This type sensor is likely to be subjected to very high temperature because the sensor has to be disposed in the vicinity of the engine due to limited space in an engine room. Accordingly, the differential amplifier circuit which is provided to amplify the output of the sensor is also subjected to high temperature. In view of the above, an element such as a GaAs device which has high responsibility under high ambient temperature is selected as an active element in the amplifier circuit.

More specifically, in case of the differential amplifier circuit being employed to amplify the output of the sensor for detecting the rotation angle of the crank shaft, it is assumed that the maximum rotation speed of an ordinary combustion engine is about 12,000 rpm, that is 12,000/60 = 200 Hz. If a resolution power for detecting the rotation angle of the crank shaft is set to 1, 200 x 360 = 72,000, that is a filtering frequency of a low-pass filter is selected to be higher 72 KHz. If a differential amplifier is employed, which includes a GaAs device suitable for high speed operation, the device has the switching transient less than 1 nsec., and thus the switching frequency of the switching units is set to less than 10 MHz. In this case, it should be noted that it is unnecessary to set the switching frequency at an exact value if it is less than 10 MHz and is sufficiently higher than 72 KHz. However, it is indispensable that the switching signal has a duty ratio of 50 %.

Fig. 5(A) is a diagram showing an example of a circuit capable of producing a switching signal which is met with the above indispensable requirement. The circuit comprises an oscillator such as a multivibrator, a ring oscillator and the like and a toggle flip-flop circuit operable in response to a clock signal produced by the oscillator. Fig. 5(B) is a diagram showing an example of waveforms of output signals of the oscillator and the F/F circuit.

Although the differential amplifier 11 using GaAs MESFETs as amplifying active elements is used in this embodiment, a differential amplifier using FETs made of another material as amplifying active elements may be used. Further, the amplifying active elements of the differential amplifier are not limited to FETs but may be bipolar junction transistors.

As described above, in the differential amplifier circuit according to the present invention, the offset voltage is completely removed, and therefore even in the case where GaAs MESFETs having large variations in the manufacturing process are used as amplifying active elements, the offset voltage caused by the process variations can be removed substantially. That is, substantially the same output as that of an ideal differential amplifier can be obtained.

## Claims

1. A differential amplifier circuit having input terminals to which input signals are applied comprising:
    a first switching means for inverting the polarity of a signal representing a potential difference between the input signals;

4

a differential amplifier for amplifying an output of said first switching means;

a second switching means for inverting the polarity of an output signal of said differential amplifier in synchronization with the switching of said first switching means; and

filter means for removing an AC component from an output of said second switching means to be output as an output of said differential amplifier circuit.

2. A differential amplifier circuit as defined in claim 1 wherein the switching of said first and second switching means is carried out with a duty ratio of 50%.

3. A differential amplifier circuit as defined in claim 1 wherein cut-off frequency of said filter means is a low-pass filter having a cut-off frequency sufficiently lower than the frequency of the switching of said first and second switching means.

FIG. 1

FIG. 5(A)

FIG. 5(B)

OUTPUT OF OSC

OUTPUT OF TFF

TIME

EP 0 460 564 A1

FIG. 2(A)

OUTPUT Vout

25

OFFSET VOLTAGE ( +A × △V )

0

INPUT Vin

FIG. 2(B)

OUTPUT Vout

26

OFFSET VOLTAGE
( +A × △V )

0

INPUT Vin

FIG. 2(C)

OUTPUT Vout

27

0

INPUT Vin

OFFSET VOLTAGE
( −A × △V )

7

# FIG. 3

OUTPUT

$(A \times Vin + A \times \Delta V)$
$(A \times Vin)$
$(A \times Vin - A \times \Delta V)$

0

TIME

# FIG. 4

10 — $V_{DD}$

7    8

3

OUTPUT

1

INPUT

5    6    4

2

9

11 — $V_{SS}$

8

European
Patent Office

EUROPEAN SEARCH
REPORT

Application Number

EP 91 10 9013

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 138 649 (G.L. SCHAFFER)<br>* column 2, line 42 - column 3, line 18; figures 1-3 * * column 3, line 38 - column 4, line 52 *<br>- - - | 1-3 | H 03 F 3/45 |
| X | US-A-4 392 112 (O.H. SCHADE)<br>* column 2, line 53 - column 4, line 27; figure 1 *<br>- - - - - | 1-3 | |

TECHNICAL FIELDS
SEARCHED (Int. Cl.5)

H 03 F

The present search report has been drawn up for all claims

| Place of search | Date of completion of search | Examiner |
|---|---|---|
| The Hague | 04 September 91 | TYBERGHIEN G.M.P. |